# EUROPÄISCHE PATENTSCHRIFT

(11) **EP 1 568 127 B1**
(45) Veröffentlichungstag und Bekanntmachung des Hinweises auf die Patenterteilung: **02.01.2008**
(21) Anmeldenummer: 03785536.8
(22) Anmeldetag: 25.11.2003
(51) Int. Cl.: H03G 3/20

(54) **VERSTÄRKERANORDNUNG, EMPFÄNGER MIT DER VERSTÄRKERANORDNUNG UND VERFAHREN ZUM BETRIEB EINES PROGRAMMIERBAREN VERSTÄRKERS**
AMPLIFIER ASSEMBLY, RECEIVER COMPRISING SAID ASSEMBLY AND METHOD FOR OPERATING A PROGRAMMABLE AMPLIFIER
ENSEMBLE AMPLIFICATEUR, RECEPTEUR COMPRENANT CET ENSEMBLE ET PROCEDE POUR FAIRE FONCTIONNER UN AMPLIFICATEUR PROGRAMMABLE

(30) Priorität: 28.11.2002 DE 10255606
(43) Veröffentlichungstag der Anmeldung: 31.08.2005
(73) Patentinhaber: Infineon Technologies AG, 81669 München (DE)
(72) Erfinder: WAGNER, Elmar, 47269 Duisburg (DE)
(74) Vertreter: Epping - Hermann - Fischer
(86) Internationale Anmeldenummer: PCT/DE2003/003895
(87) Internationale Veröffentlichungsnummer: WO 2004/049563

(56) Entgegenhaltungen:
- GB-A- 1 075 341
- US-A- 3 969 683
- US-A- 4 091 380
- US-A- 4 301 445
- US-A- 5 548 616
- US-A- 5 659 582

## Beschreibung

Die vorliegende Erfindung betrifft eine Verstärkeranordnung, einen Empfänger mit der Verstärkeranordnung sowie ein Verfahren zum Betrieb eines programmierbaren Verstärkers.

Es sind verschiedene, digitale Modulationsverfahren bekannt, bei denen in Abhängigkeit von zu sendenden Nutzdaten die Phasenlage, die Frequenz, die Amplitude eines Trägersignals oder Kombinationen davon variiert werden.

Bei dem weit verbreiteten Mobilfunkstandard GSM, Global System for Mobile Communication, wird als Modulationsverfahren GMSK, Gauss'sches Minimum Shift Keying, verwendet. Dabei handelt es sich um ein phasenkontinuierliches Frequenzumtastungsverfahren mit einem Modulationsindex von 0,5, bei dem für die Daten Gauss-Impulse anstelle von Rechteck-Impulsen verwendet werden.

Um der Nachfrage nach der Übertragung immer höherer Datenmengen gerecht zu werden, setzt man anstelle von Frequenzumtastungsverfahren zunehmend kombinierte Phasen- und Amplitudentastungen ein. Bei diesen ist ein Teil der Signalinformation in der Signalamplitude enthalten. Dabei ist es erforderlich, Verstärker einzusetzen, die hohen Linearitätsanforderungen genügen. Diese Verstärker müssen jedoch in Abhängigkeit von der Empfangsfeldstärke in ihrer Verstärkung geregelt werden, um am Empfängerausgang für gleichbleibende Amplitudenverhältnisse zu sorgen, damit die Demodulation der Daten optimal gelingen kann.

Die Empfangsfeldstärke hängt bei den unterschiedlichen Mobilfunkverfahren üblicherweise von der gewählten Trägerfrequenz ab. Grund hierfür sind die frequenzabhängigen Kanaleigenschaften bei der Signalübertragung.

Normalerweise werden derzeit bei Funkempfängern für Modulationsverfahren, bei denen eine Phasen- und Amplitudenumtastung verwendet wird, Signalverstärker mit programmierbarer Verstärkung verwendet, einer sogenannten PGC, Programmable Gain Control.

Bei verbreiteten Mobilfunkstandards, wie beispielsweise GSM, welche die Datenübertragung in sogenannten Zeitschlitzen, Slots, organisieren, wird die Empfangsverstärkung bisher in Abhängigkeit von einer Auswertung des Empfangssignals im vorangegangenen Zeitschlitz eingestellt. Das im aktuellen Zeitschlitz empfangene Signal wird demnach nachteilhafterweise mit der für den vorangegangenen Zeitschlitz geltenden, optimalen Verstärkungseinstellung empfangen.

Bei einigen, mit Zeitschlitzen arbeitenden Funksystemen wird jedoch ein Frequenzsprungverfahren, englisch: frequency hopping, eingesetzt, das heisst, dass nach einem vorbekannten Muster in jedem Zeitschlitz auf einer anderen Frequenz gesendet wird. Aufgrund der frequenzabhängigen Kanaleigenschaften des Funksignals ergeben sich damit jedoch nachteilhafterweise in jedem Zeitschlitz unterschiedliche Empfangsfeldstärken.

Folglich macht ein wie beschrieben arbeitender Algorithmus zur Verstärkungseinstellung, der die Signalamplitude des vorangegangenen Zeitschlitzes als Grundlage zur Verstärkungseinstellung verwendet, prinzipiell einen Fehler. Dieser Fehler muß durch einen höheren Dynamikbereich am Ausgang des Verstärkers und eine größere Bandbreite des nachgeschalteten Analog-/Digital(A/D)-Wandlers ausgeglichen werden.

Eine Möglichkeit, eine Ausregelung einer schwankenden Empfangsfeldstärke im Funkempfänger zu realisieren, ist die automatische Verstärkungsregelung, die sogenannte AGC, Automatic Gain Control, wie sie früher in AM-Rundfunkempfängern eingesetzt wurde. Dies hätte jedoch den Nachteil, dass die Amplitudeninformation des Nutzsignals verfälscht würde, da die AGC langsame Schwankungen der Amplitude, die im Nutzsignal vorhanden sein können, ausregelt.

In dem Dokument DE 1 466 163 ist eine selbsttätig abgestimmte Hochfrequenzschaltung mit einer Anordnung zur selbsttätigen Verstärkungsregelung angegeben. Dabei soll die Verstärkung in einem Übertragungskanal ohne Verwendung mechanischer Einrichtungen automatisch geregelt werden. Zu diesem Zweck ist eine binär abgestufte Dämpfungseinrichtung gezeigt, die von einem vielstufigen binären Registerschalter angesteuert wird. Der vielstufige binäre Registerschalter wird von einem Multivibrator angesteuert. Weiterhin ist ein Komparator vorgesehen, der zwischen einen der Dämpfungseinrichtung nachgeschalteten Verstärker und den Multivibrator geschaltet ist.

In den Dokumenten US 5 548 616, GB 1 075 341, US 4 301 445 und US 5 659 582 werden AGC-Schaltungen mit Zählern offenbart.

Aufgabe der vorliegenden Erfindung ist es, einen Empfänger mit einer Verstärkeranordnung sowie ein Verfahren zum Betrieb eines programmierbaren Verstärkers in einem Empfänger anzugeben, bei denen durch Frequenzsprungverfahren bedingte Amplitudenschwankungen ausgeregelt werden können.

Erfindungsgemäß wird die Aufgabe bezüglich der Verstärkeranordnung gelöst durch einen Empfänger mit einer Verstärkeranordnung für in Zeitschlitzen organisierte Datenübertragung, umfassend
- einen programmierbaren Verstärker (5) mit einem Signaleingang, einem Signalausgang und einem Programmiereingang (6) zum Einstellen der Verstärkung,
- einen Vergleicher (8), der an den Signalausgang angeschlossen ist, ausgebildet zur Abgabe eines Steuersignals an einem Ausgang, wenn der Signalpegel am Signalausgang (OUT) größer als ein vorgebbarer Referenzpegel (REF) ist, zu Beginn eines Zeitschlitzes, und
- einen Zähler (10) mit einen Inkrementierungseingang (9) zum Inkrementieren des Zählwerts, der an den Ausgang des Vergleichers (8) angeschlossen ist, und mit einem Zählwertausgang, der an den Programmiereingang (6) des Verstärkers (5) angeschlossen ist zur Programmierung des Verstärkers (5), zu Beginn des Zeitschlitzes, wobei
- der programmierbare Verstärker (5) mit seinem Signaleingang über einen Abwärts-Frequenzumsetzer (3) an ein Mittel zum Einkoppeln eines modulierten Signals (1) angeschlossen ist und mit seinem Signalausgang an einen Demodulator (7) zum Demodulieren des modulierten Signals angeschlossen ist.

Gemäß dem vorgeschlagenen Prinzip ist der Verstärker als programmierbarer Verstärker ausgebildet mit einem Programmiereingang zum Einstellen des Verstärkungsfaktors. Der Vergleicher, der an den Ausgang des programmierbaren Verstärkers angeschaltet ist, vergleicht wiederholt den Ausgangspegel am Signalausgang des Verstärkers mit einem Referenzpegel und gibt ein Steuersignal ab, welches dieses Vergleichsergebnis repräsentiert. Mit einem Zähler, der bevorzugt durch ein Taktsignal angesteuert wird, erfolgt ein schrittweises Inkrementieren des Zählwertes in Abhängigkeit von dem durch den Vergleicher abgegebenen Steuersignal. Die Programmierung des Verstärkers, also das Einstellen der Verstärkung, erfolgt dabei stets in Abhängigkeit vom aktuellen Zählwert, den der Zähler an einem Zählwertausgang bereitstellt.

Die Regelung der Programmierung des Verstärkungswertes kann gemäß dem vorgeschlagenen Prinzip mit Vorteil sehr schnell erfolgen, beispielsweise während der ersten ein oder zwei Datenbits innerhalb eines Zeitschlitzes.

Die Nachführung des Verstärkers in Abhängigkeit von der aktuellen Empfangsfeldstärke eines Signals oder allgemein von dem Signalpegel eines zu verstärkenden Signals bietet den Vorteil, dass die Verstärkungsregelung nicht mehr in Abhängigkeit der Signalverhältnisse im vorangegangenen Zeitschlitz erfolgt, sondern dass tatsächlich die Signalgegebenheiten im aktuellen Zeitschlitz berücksichtigt werden können. Somit ergibt sich auch bei Einsatz von Frequenzsprungverfahren stets ein gleichbleibender Signalpegel am Verstärkerausgang. Dies wiederum ermöglicht ein zuverlässiges Demodulieren eines phasen- und amplitudenumgetasteten Signals.

In einer bevorzugten Weiterbildung des vorgeschlagenen Prinzips weist der Zähler einen Rücksetzeingang auf zum Rücksetzen des Zählwertes. Das Rücksetzen des Zählwertes erfolgt dabei bevorzugt vor Beginn eines Zeitschlitzes zur Übertragung eines Nutzsignals.

Gemäß einer Weiterbildung des vorgeschlagenen Prinzips ist bei rückgesetztem Zähler an dem programmierbaren Verstärker die größte programmierbare Verstärkung eingestellt.

Demnach wird am Anfang eines Zeitschlitzes zunächst die Verstärkung auf den größten einstellbaren Wert eingestellt. Wenn das Empfangssignal eintrifft, wird der Ausgang des Verstärkers zunächst einmal übersteuert sein. Anschließend wird sehr schnell mit der beschriebenen Regelschleife am programmierbaren Verstärker der Verstärkungswert so weit reduziert, bis der Ausgangssignalpegel nicht mehr den Referenzpegel überschreitet. Die Reduzierung der Verstärkung, welche dem Inkrementieren des Zählers entspricht, erfolgt dabei schrittweise oder rekursiv.

Somit wird der Verstärkungsfaktor schon zu Beginn des Zeitschlitzes so weit reduziert, dass der Empfänger das Signal korrekt empfangen kann. Der dabei ermittelte Verstärkungswert wird dabei bevorzugt für den gesamten Zeitschlitz beibehalten. Dadurch ist eine sogenannte Peak-Hold Funktionalität implementiert.

Die Tatsache, dass zu Beginn eines Zeitschlitzes einige Bits an Nutzinformation verloren gehen können, bis der richtige Verstärkungswert gefunden ist, ist normalerweise insofern unproblematisch, als zu Beginn von Zeitschlitzen ohnehin normalerweise zunächst Synchronisationsdaten, Trainingssequenzen oder ähnliches übermittelt werden, jedoch keine Nutzdaten im eigentlichen Sinne.

Wie bereits erläutert, kommt das vorgeschlagene Prinzip besonders vorteilhaft bei Anwendung des Verstärkers in der Empfangssignalverarbeitungskette eines Funkempfängers zum Tragen. Insbesondere ist der beschriebene, programmierbare Verstärker vorteilhaft in solchen Empfängern anwendbar, welche mit einer Modulation mit Amplituden- und Phasenvariation arbeiten, sowie zusätzlich die Signalübertragung in Zeitschlitzen organisieren und Frequenzsprungverfahren einsetzen. Diese werden auch als Frequency Hopping Verfahren bezeichnet.

Bezüglich des Verfahrens wird die Aufgabe gelöst durch ein Verfahren zum Betrieb eines programmierbaren Verstärkers (5) in einem Empfänger bei in Zeitschlitzen organisierter Datenübertragung, umfassend folgende Verfahrensschritte:
- Programmieren der größten einstellbaren Verstärkung des programmierbaren Verstärkers (5),
- Anlegen eines Eingangssignals an den programmierbaren Verstärker (5) und Vergleichen des Ausgangspegels (OUT) des programmierbaren Verstärkers (5) mit einem Referenzpegel (REF) zu Beginn eines Zeitschlitzes und
- Schrittweises Reduzieren der Verstärkung des programmierbaren Verstärkers (5) so lange, bis der Ausgangspegel (OUT) des programmierbaren Verstärkers (5) nicht mehr über dem Referenzpegel (REF) liegt, zu Beginn des Zeitschlitzes.

Dabei wird zunächst die maximale Verstärkung des Verstärkers eingestellt. Wenn das verstärkte Signal am Pegeldetektor, das heißt an einem Vergleicher, einen Referenzpegel überschreitet, wird die Verstärkung schrittweise reduziert. Die Reduzierung der Verstärkung erfolgt so lange, wie der Ausgangspegel mit reduzierter Verstärkung immer noch größer als der Referenzpegel ist. Dies endet, sobald der Ausgangspegel des Verstärkers nicht mehr über dem Referenzpegel liegt. Dann bleibt die Verstärkung konstant. Somit wird eine Peak-Hold Funktionalität implementiert.

Die Taktrate des schrittweisen Reduzierens der Verstärkung kann deutlich schneller sein als die Nutzdatenrate, da die beschriebene Regelschleife keine langsamen Filter aufweist. Folglich kann sich die Regelschleife innerhalb weniger Bits zu Beginn des Zeitschlitzes auf den richtigen Pegel einstellen. Somit ist eine zuverlässige und präzise Demodulation eines amplituden- und phasenumgetasteten Signals auch bei durch Frequenzsprungverfahren schwankende Empfangsfeldstärke möglich.

Die Ansteuerung des programmierbaren Verstärkers und dessen Programmierung in der Regelschleife erfolgt bevorzugt mit einem Zähler, dessen Zählwert schrittweise so lange inkrementiert wird, bis der Ausgangspegel des programmierbaren Verstärkers nicht mehr über dem Referenzpegel liegt. Dabei bewirkt ein Inkrementieren des Zählers eine Reduzierung der Verstärkung.

Weiter bevorzugt wird die Verstärkung des programmierbaren Verstärkers so lange schrittweise noch weiter reduziert, bis der Ausgangspegel des programmierbaren Verstärkers nicht mehr über dem Referenzpegel einschließlich einer Übersteuerungsreserve zur weiteren Signalverarbeitung liegt. Eine derartige weitere Signalverarbeitung kann beispielsweise in einer Analog-/Digital-Wandlung mit nachfolgender, digitaler Demodulation bestehen.

Der programmierbare Verstärker ist bevorzugt in einer dB-linearen Abstufung programmierbar ausgebildet.

Bevorzugt ist der programmierbare Verstärker in konstanten, also gleich großen dB-Schritten programmierbar ausgebildet.

Man erkennt, dass gemäß dem vorgeschlagenen Prinzip vorteilhafterweise solche Analog-/Digital-Wandler eingesetzt werden können, deren Dynamikbereich nicht bedeutend größer zu sein braucht als der Dynamikumfang der Amplitudenmodulation des Signals. Somit kann die A/D-Wandlung mit deutlich geringerem Aufwand bei dennoch verbesserter Genauigkeit und Auflösung erfolgen.

Weitere Einzelheiten und vorteilhafte Ausgestaltungen des beschriebenen Prinzips sind Gegenstand der Unteransprüche.

Die Erfindung wird nachfolgend an einem Ausführungsbeispiel anhand der Zeichnungen näher erläutert.

Es zeigen:
- Figur 1: ein Blockschaltbild eines beispielhaften Empfängers mit einer dem vorgeschlagenen Prinzip entsprechenden Verstärkeranordnung und
- Figur 2: den Verlauf der Ausgangsleistung über der Zeit bei einem beispielhaften Zeitschlitz zur Verarbeitung durch die Schaltung gemäß Figur 1.

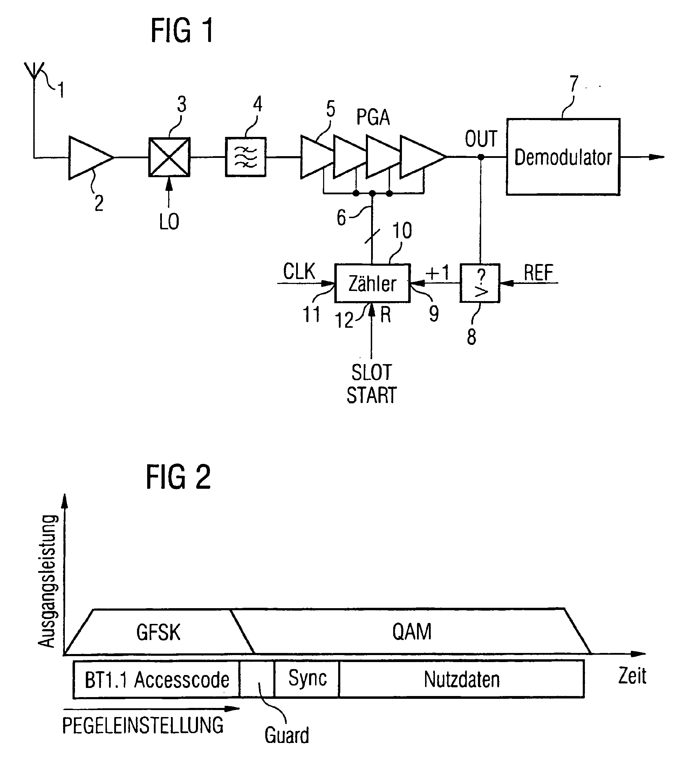

Figur 1 zeigt ein Blockschaltbild eines Funkempfängers mit einer heterodynen Empfängerarchitektur. Über eine Antenne 1 wird ein hochfrequentes, moduliertes Signal eingekoppelt und mit einem der Antenne 1 nachgeschalteten Vorverstärker 2 verstärkt. Dem Vorverstärker 2 ist ein Abwärts-Frequenzumsetzer 3 nachgeschaltet, der als Frequenzmischer ausgelegt ist und das hochfrequente, modulierte Signal mit einem Lokaloszillator - oder Überlagerungssignal LO mischt. Hierfür weist der Frequenzumsetzer 3 einen ersten Eingang auf, der mit dem Ausgang des Vorverstärkers 2 verbunden ist und einen zweiten Eingang, der ausgelegt ist zum Anschluß an einen Trägerfrequenzgenerator, der das Trägersignal LO erzeugt. An den Ausgang des Mischers 3 ist über ein als Bandpassfilter 4 ausgelegtes Kanal- oder Zwischenfrequenzfilter ein mehrstufiger, programmierbarer Verstärker 5 angeschlossen. Der programmierbare Verstärker 5, ein sogenannter Programmable Gain Amplifier, PGA, umfaßt vier Verstärkerstufen, welche je einen Steuereingang aufweisen. Die Steuereingänge der Verstärkerstufen sind zu einem Programmiereingang 6 des mehrstufigen Verstärkers zusammengefaßt.

Der Ausgangsanschluß des programmierbaren Verstärkers 5 ist an den Eingang eines Demodulators 7 angeschlossen, der ausgelegt ist zur Demodulation des modulierten Signals, welches mit dem Mischer 3 auf eine Zwischenfrequenzebene gemischt, bandpassgefiltert und verstärkt ist. Weiterhin ist an den Ausgang des programmierbaren Verstärkers 5 ein Vergleicher 8 angeschlossen. Der Vergleicher 8 hat einen weiteren Eingang zur Zuführung eines Referenzpegels REF. Der Ausgang des Vergleichers 8 ist an einen Aktiviereingang 9 eines Zählers 10 angeschlossen. Der Zähler 10 umfaßt weiterhin einen Takteingang 11 und einen Rücksetzeingang 12, welche zum Zuführen eines Taktsignals CLK beziehungsweise eines Reset-Signals R ausgelegt sind. Der Zähler 10 hat außerdem einen Zählwertausgang, der mit dem Programmiereingang 6 des Verstärkers 5 verbunden ist.

Zu Beginn eines Empfangszeitschlitzes in einem empfangenen Nutzsignal des Empfängers gemäß Figur 1 ist die größtmögliche Verstärkung am programmierbaren Verstärker 5 programmiert. Hierfür wird bereits vor Beginn des Zeitschlitzes der Zähler 10 am Rücksetzeingang 12 rückgesetzt. Ab Beginn des Zeitschlitzes wird, in Abhängigkeit von einem Taktsignal CLK, schrittweise der Verstärkungsfaktor des Verstärkers 5 heruntergeregelt. Hierfür vergleicht in jedem Schritt der Vergleicher 8 den Ausgangspegel OUT am Verstärker 5 mit dem Referenzpegel REF. So lange der Ausgangspegel OUT noch über dem Referenzpegel REF liegt, wird in jedem Taktzyklus des Taktes CLK der Zählwert inkrementiert. Mit jedem Inkrementieren des Zählwertes wird der Verstärkungsfaktor im Verstärker 5 reduziert. Die Reduzierung des Verstärkungsfaktors erfolgt dabei in konstanten dB-Schritten, beispielsweise um -1dB pro Inkrementieren des Zählwertes. Damit wird der Ausgangspegel OUT mit der beschriebenen Regelung des Verstärkers so lange reduziert, bis der Ausgangspegel OUT nicht mehr über dem Referenzpegel REF liegt. Diese Einstellung des Verstärkers 5 erfolgt innerhalb der ersten Bit eines Zeitschlitzes des Nutsignals, während derer noch keine Amplituden-Umtastung erfolgt. Für die gesamte Restdauer des Zeitschlitzes bleibt der Verstärkungswert programmiert, so dass eine Peak-Hold Funktionalität implementiert ist.

Gemäß dem vorgeschlagenen Prinzip wird der Empfänger so in seiner Verstärkung eingestellt, dass die Signalamplitude des Signals im aktuellen Zeitschlitz anstelle der Amplitude im vorherigen Zeitschlitz verwendet wird. Dabei wird die Amplitudeninformation, die Teil der Modulationsdaten ist, während des Zeitschlitzes unverfälscht verstärkt.

Der Referenzpegel ist so gewählt, dass ein dem programmierbaren Verstärker 5 im Demodulator 7 nachgeschalteter A/D-Wandler das verstärkte Nutzsignal, vergrößert um eine festlegbare Übersteuerungsreserve, ohne Verzerrungen digitalisieren kann. Dadurch, dass zu Beginn des Zeitschlitzes die Verstärkung zunächst auf ihr Maximum gestellt wird, kann ohne Nachteil zu Beginn des Zeitschlitzes Amplitudeninformation so lange verloren gehen, bis die korrekte Verstärkungseinstellung gefunden wurde. Da jedoch bei vorliegender Anordnung kein Filter mit großer Signallaufzeit in der Regelschleife vorgesehen ist, erfolgt die Verstärkungseinstellung mit Vorteil sehr schnell.

Der Vergleicher 8 kann auch als sogenannter Pegeldetektor ausgeführt sein.

Der Inkrement-Eingang 9 des Zählers bleibt so lange aktiv, wie der Ausgangspegel OUT mit reduzierter Verstärkung immer noch größer als der Referenzpegel REF ist.

Der Zählertakt kann bei dem vorgeschlagenen Prinzip deutlich schneller sein als die Nutzdatenrate, da, wie bereits erläutert, in der Regelschleife 5, 8, 10 keine langsamen Filter vorgesehen sind. Folglich kann die sich Regelschleife 5, 8, 10 innerhalb weniger Bits zu Beginn des Zeitschlitzes auf den richtigen Empfangspegel einstellen.

Besonders vorteilhaft ist der beschriebene Empfänger für zukünftige Bluetooth-Spezifikationen anwendbar, da dort vorgesehen ist, zu Beginn jedes Zeitschlitzes zunächst eine Datenübertragung wie bei dem Bluetooth-Standard in der Version 1.1 mit GFSK stattfinden zu lassen, welche keine Amplitudeninformationen aufweist. Statt dessen wird zunächst mit maximal möglicher Ausgangsleistung gesendet. Erst in einem nachfolgenden Nutzdatenblock wird neben einer Phasen- auch eine Amplitudeninformation übermittelt. Wenn jedoch zu Beginn eines Zeitschlitzes ohnehin keine Amplitudeninformation übermittelt wird, stört auch deren Verlust nicht.

Figur 2 zeigt den Verlauf der Ausgangsleistung über der Zeit bei einem in einer zukünftigen Version einer Bluetooth-Spezifikation vorgesehenen Zeitschlitz. Dabei wird zunächst ein sogenannter Access-Code übermittelt, welcher den Spezifikationen des Bluetooth-Standards 1.1 entspricht. Dieser verwendet eine Gauss'sche Frequenzumtastung und trägt somit keine Amplitudeninformation. Nach einem sogenannten Guard- und einem Synchronisations-Block werden für den Rest des Zeitschlitzes Nutzdaten übertragen, welche phasen- und amplitudenmoduliert sind, beispielsweise in einer Quadratur-Amplituden-Modulation. Somit kann die gesamte Zeitdauer des Access-Codes verwendet werden, um den Verstärker 5 wie in Figur 1 gezeigt bezüglich seines Verstärkungswertes zu programmieren.

Das vorgeschlagene Prinzip ist jedoch nicht nur für Bluetooth-Anwendungen geeignet. Vielmehr ist es bei fast allen digitalen Funkübertragungssystemen üblich, zu Beginn eines Zeitschlitzes Trainingssequenzen, Synchronisationsdaten et cetera, jedoch zu Beginn keine Nutzdaten zu senden. Insgesamt kann das beschriebene Prinzip bei allen Funksystemen zur Anwendung kommen, bei denen auf die Amplitudeninformation der ersten zwei bis drei Bits eines Zeitschlitzes verzichtet werden kann.

Wenn darüber hinaus, wie ohnehin üblich, der Sender bereits vor der Übermittlung der ersten Bits des Zeitschlitzes eingeschaltet wird, werden sogar die ersten zwei bis drei Bits nicht verloren gehen.

Das vorgeschlagene Prinzip kommt insbesondere bei Frequenzsprungverfahren vorteilhaft zur Anwendung, da die Empfangsfeldstärke und damit auch die Amplitudenverhältnisse des Nutzsignals von den frequenzabhängigen Eigenschaften des Übertragungskanals beeinflusst werden.

### Bezugszeichenliste

- 1: Antenne
- 2: Vorverstärker
- 3: Mischer
- 4: Bandpassfilter
- 5: programmierbarer Verstärker
- 6: Programmiereingang
- 7: Demodulator
- 8: Vergleicher
- 9: Inkrementiereingang
- 10: Zähler
- 11: Takteingang
- 12: Rücksetzeingang
- CLK: Taktsignal
- GFSK: Gauss'sche Frequenzumtastung
- LO: Lokaloszillatorsignal
- OUT: Ausgangspegel
- QAM: Quadratur Amplituden Modulation
- R: Reset-Signal
- REF: Referenzpegel

## Patentansprüche

1. Empfänger mit einer Verstärkeranordnung für in Zeitschlitzen organisierte Datenübertragung, umfassend
- einen programmierbaren Verstärker (5) mit einem Signaleingang, einem Signalausgang und einem Programmiereingang (6) zum Einstellen der Verstärkung,
- einen Vergleicher (8), der an den Signalausgang angeschlossen ist, ausgebildet zur Abgabe eines Steuersignals an einem Ausgang, wenn der Signalpegel am Signalausgang (OUT) größer als ein vorgebbarer Referenzpegel (REF) ist, zu Beginn eines Zeitschlitzes, und
- einen Zähler (10) mit einen Inkrementierungseingang (9) zum Inkrementieren des Zählwerts, der an den Ausgang des Vergleichers (8) angeschlossen ist, und mit einem Zählwertausgang, der an den Programmiereingang (6) des Verstärkers (5) angeschlossen ist zur Programmierung des Verstärkers (5), zu Beginn des Zeitschlitzes, wobei
- der programmierbare Verstärker (5) mit seinem Signaleingang über einen Abwärts-Frequenzumsetzer (3) an ein Mittel zum Einkoppeln eines modulierten Signals (1) angeschlossen ist und mit seinem Signalausgang an einen Demodulator (7) zum Demodulieren des modulierten Signals angeschlossen ist.

2. Empfänger nach Anspruch 1,
**dadurch gekennzeichnet, dass**
der Zähler (10) einen Rücksetzeingang (12) aufweist zum Rücksetzen des Zählwerts.

3. Empfänger nach Anspruch 2,
**dadurch gekennzeichnet, dass**
bei rückgesetztem Zähler (10) an dem programmierbaren Verstärker (5) die größte programmierbare Verstärkung eingestellt ist.

4. Empfänger nach einem der Ansprüche 1 bis 3,
**dadurch gekennzeichnet, dass**
der programmierbaren Verstärker (5) mehrstufig aufgebaut ist umfassend mehrere Verstärkerstufen mit je einem Steuereingang zum Einstellen der Verstärkung, wobei die Steuereingänge gemeinsam den Programmiereingang (6) des programmierbaren Verstärkers zum Einstellen der Verstärkung bilden.

5. Empfänger nach einem der Ansprüche 1 bis 4,
**dadurch gekennzeichnet, dass**
der programmierbare Verstärker (5) mit einer dB-linearen Abstufung programmierbar ausgeführt ist.

6. Verfahren zum Betrieb eines programmierbaren Verstärkers (5) in einem Empfänger bei in Zeitschlitzen organisierter Datenübertragung, umfassend folgende Verfahrensschritte:
- Programmieren der größten einstellbaren Verstärkung des programmierbaren Verstärkers (5),
- Anlegen eines Eingangssignals an den programmierbaren Verstärker (5) und Vergleichen des Ausgangspegels (OUT) des programmierbaren Verstärkers (5) mit einem Referenzpegel (REF) zu Beginn eines Zeitschlitzes und
- Schrittweises Reduzieren der Verstärkung des programmierbaren Verstärkers (5) so lange, bis der Ausgangspegel (OUT) des programmierbaren Verstärkers (5) nicht mehr über dem Referenzpegel (REF) liegt, zu Beginn des Zeitschlitzes.

7. Verfahren nach Anspruch 6,
**dadurch gekennzeichnet, dass**
ein Zählwert in einem den programmierbaren Verstärker (5) ansteuernden Zähler (10) zur Reduzierung der Verstärkung solange schrittweise inkrementiert wird, bis der Ausgangspegel (OUT) des programmierbaren Verstärkers (5) nicht mehr über dem Referenzpegel (REF) liegt.

8. Verfahren nach Anspruch 6 oder 7,
**dadurch gekennzeichnet, dass**
die Verstärkung des programmierbaren Verstärkers (5) solange schrittweise reduziert wird, bis der Ausgangspegel (OUT) des programmierbaren Verstärkers (5) nicht mehr über dem Referenzpegel (REF) einschließlich einer Übersteuerungsreserve zur weiteren Signalverarbeitung liegt.

## Claims

1. Receiver comprising an amplifier assembly for data transmission organized in time slots, comprising
- a programmable amplifier (5) with a signal input, a signal output and a programming input (6) for setting the gain,
- a comparator (8), which is connected to the signal output, designed for outputting a control signal at an output if the signal level at the signal output (OUT) is greater than a predeterminable reference level (REF), at the beginning of the time slot, and
- a counter (10) with an incrementing input (9) for incrementing the count, which is connected to the output of the comparator (8), and with a count output connected to the programming input (6) of the amplifier (5) for programming of the amplifier (5), at the beginning of the time slot, wherein
- the programmable amplifier (5) is connected by its signal input, via a frequency down converter (3), to a means for coupling in a modulated signal (1) and is connected by its signal output to a demodulator (7) for demodulating the modulated signal.

2. Receiver according to Claim 1,
**characterized in that**
the counter (10) has a reset input (12) for resetting the count.

3. Receiver according to Claim 2,
**characterized in that**
the largest programmable gain is set at the programmable amplifier (5) with the counter (10) reset.

4. Receiver according to one of Claims 1 to 3,
**characterized in that**
the programmable amplifier (5) is constructed in multistage fashion comprising a plurality of amplifier stages with a respective control input for setting the gain, the control inputs jointly forming the programming input (6) of the programmable amplifier for setting the gain.

5. Receiver according to one of Claims 1 to 4,
**characterized in that**
the programmable amplifier (5) is embodied in programmable fashion with a dB-linear gradation.

6. Method for operating a programmable amplifier (5) in a receiver in the case of data transmission organized in time slots, comprising the following method steps:
- programming of the largest settable gain of the programmable amplifier (5),
- application of an input signal to the programmable amplifier (5) and comparison of the output level (OUT) of the programmable amplifier (5) with a reference level (REF), at the beginning of a time slot, and
- step-by-step reduction of the gain of the programmable amplifier (5) until the output level (OUT) of the programmable amplifier (5) no longer lies above the reference level (REF), at the beginning of the time slot.

7. Method according to Claim 6,
**characterized in that**
a count in a counter (10) that drives the programmable amplifier (5) is incremented step by step for the purpose of reducing the gain until the output level (OUT) of the programmable amplifier (5) no longer lies above the reference level (REF).

8. Method according to Claim 6 or 7,
**characterized in that**
the gain of the programmable amplifier (5) is reduced step by step until the output level (OUT) of the programmable amplifier (5) no longer lies above the reference level (REF) including an overdriving margin for further signal processing.

## Revendications

1. Récepteur comportant un dispositif amplificateur pour la transmission de données organisée dans des fenêtres temporelles, ledit récepteur comportant
- un amplificateur programmable (5) comportant une entrée de signal, une sortie de signal et une entrée de programmation (6) destinée à régler l'amplification,
- un comparateur (8) qui est raccordé à la sortie de signal, et qui est conformé de façon à délivrer un signal de commande à une sortie lorsque le niveau de signal à la sortie de signal (OUT) est supérieur à un niveau de référence pouvant être prescrit (REF) au début d'une fenêtre temporelle, et
- un compteur (10) comportant une entrée d'incrémentation (9), qui est destinée à incrémenter la valeur de comptage et qui est raccordée à la sortie du comparateur (8), et une sortie de valeur de comptage qui est raccordée à l'entrée de programmation (6) de l'amplificateur (5), afin de programmer l'amplificateur (5) au début de la fenêtre temporelle,
- l'amplificateur programmable (5) étant raccordé par son entrée de signal, par l'intermédiaire d'un convertisseur abaisseur de fréquence (3), à un moyen de couplage d'un signal modulé (1) et par sa sortie de signal à un démodulateur (7) destiné à démoduler le signal modulé.

2. Récepteur selon la revendication 1, **caractérisé en ce que** le compteur (10) comporte une entrée de réinitialisation (12) destinée à réinitialiser la valeur de comptage.

3. Récepteur selon la revendication 2, **caractérisé en ce que** la plus grande amplification programmable est réglée au niveau de l'amplificateur programmable (5) une fois que le compteur (10) est réinitialisé.

4. Récepteur selon l'une des revendications 1 à 3, **caractérisé en ce que** l'amplificateur programmable (5) a une structure à étages multiples et comporte plusieurs étages d'amplification dotés chacun d'une entrée de commande destiné à régler l'amplification, les entrées de commande formant ensemble l'entrée de programmation (6) de l'amplificateur programmable afin de régler l'amplification.

5. Récepteur selon l'une des revendications 1 à 4, **caractérisé en ce que** l'amplificateur programmable (5) est réalisé de façon à être programmable avec un échelonnement linéaire en dB.

6. Procédé d'utilisation d'un amplificateur programmable (5) dans un récepteur pour une transmission de données organisée dans des fenêtres temporelles, ledit procédé comportant les étapes suivantes consistant à :
- programmer la plus grande amplification réglable de l'amplificateur programmable (5),
- appliquer un signal d'entrée à l'amplificateur programmable (5) et comparer le niveau de sortie (OUT) de l'amplificateur programmable (5) avec un niveau de référence (REF) au début d'une fenêtre temporelle et
- réduire par pas l'amplification de l'amplificateur programmable (5) jusqu'à ce que le niveau de sortie (OUT) de l'amplificateur programmable (5) ne se trouve plus au-dessus du niveau de référence (REF) au début de la fenêtre temporelle.

7. Procédé selon la revendication 6, **caractérisé en ce que**, pour réduire l'amplification, un compteur (10), commandant l'amplificateur programmable (5), est incrémenté par pas jusqu'à ce que le niveau de sortie (OUT) de l'amplificateur programmable (5) ne se trouve plus au-dessus du niveau de référence (REF).

8. Procédé selon la revendication 6 ou 7, **caractérisé en ce que** l'amplification de l'amplificateur programmable (5) est réduit par pas jusqu'à ce que le niveau de sortie (OUT) de l'amplificateur programmable (5) ne se trouve plus au-dessus du niveau de référence (REF), y compris une réserve de surmodulation, en vue du traitement de signal ultérieur.
